# EUROPEAN PATENT APPLICATION

(11) **EP 4 793 411 A1**
(43) Date of publication of application: **19.08.2026**
(21) Application number: 25170426.8
(22) Date of filing: 14.04.2025
(51) Int. Cl.: C30B 15/04, C30B 15/14

(54) **SINGLE CRYSTAL FURNACE AND METHOD FOR MANUFACTURING SILICON SINGLE CRYSTALS**

(30) Priority: 12.02.2025 CN 202510157852
(71) Applicant: JINKO SOLAR CO., LTD, ShangRao, Jiangxi 334100 (CN)
(72) Inventor: CHEN, Zhancang, Shangrao Economic Development Zone, Jiangxi, 334100 (CN); OU, Ziyang, Shangrao Economic Development Zone, Jiangxi, 334100 (CN); SONG, Liping, Shangrao Economic Development Zone, Jiangxi, 334100 (CN); LI, Xiaolong, Shangrao Economic Development Zone, Jiangxi, 334100 (CN); ZHAO, Yuzhi, Shangrao Economic Development Zone, Jiangxi, 334100 (CN)
(74) Representative: Balder IP Law, S.L.

(57) **Abstract**

Embodiments of the present disclosure relate to the field of photovoltaics, and provide a single crystal furnace and a method for manufacturing single crystal silicon rods. The single crystal furnace includes: a furnace body including a first accommodating space, a second accommodating space, and a third accommodating space arranged in sequence along a first direction and communicated with each other, where the first accommodating space is configured to accommodate silicone fluids; a liquid-cooled shield and connectors, where the liquid-cooled shield is arranged in the second accommodating space and includes an inner wall surface and an outer wall surface opposite to each other; a movable device fixed on an outer wall of the furnace body and is connected to the connectors, where the movable device is configured to move the liquid-cooled shield by moving the connectors; a flange fixed on the movable device, where a liquid inlet and a gas inlet are defined on the flange; a liquid feeding pipeline communicated with the liquid inlet, where the liquid feeding pipeline extends into the second accommodating space and communicates with the liquid-cooled shield; and a gas intake pipeline communicated with the gas inlet, where the gas intake pipeline extends into the second accommodating space and is fixed on the inner wall surface of the liquid-cooled shield, and the gas intake pipeline includes first gas outlets facing the inner wall surface of the liquid-cooled shield. The single crystal furnace and the method can improve the performance of the manufactured single crystal silicon rods.

## Description

### TECHNICAL FIELD

Embodiments of the present disclosure relate to the field of photovoltaics, and in particular to a single crystal furnace and a method for manufacturing single crystal silicon rods.

### BACKGROUND

With the worsening situation of energy shortage, the development and utilization of renewable energy sources are urgent. Among numerous renewable energy sources, solar energy has outstanding advantages such as no depletion risk, safety and reliability, no noise, no pollution emissions, and less limited application by resource distribution regions.

The solar cells may include solar cells of crystalline silicon and solar cells of amorphous silicon, and the solar cells of crystalline silicon may in turn include solar cells of monocrystalline silicon and solar cells of polycrystalline silicon. Generally, monocrystalline silicon is used for the substrates of the solar cells of monocrystalline silicon.

The single crystal furnaces are important apparatus for manufacturing monocrystalline silicon. At present, it is necessary to design a single crystal furnace to improve the performance of the manufactured single crystal silicon rods.

### SUMMARY

The embodiments of the present disclosure provide a single crystal furnace and a method for manufacturing single crystal silicon rods, which can at least improve the performance of the manufactured single crystal silicon rods.

Some embodiments of the present disclosure provide a single crystal furnace, including: a furnace body including a first accommodating space, a second accommodating space, and a third accommodating space arranged in sequence along a first direction and communicated with each other, where the first accommodating space is configured to accommodate silicone fluids; a liquid-cooled shield and connectors, where the liquid-cooled shield is arranged in the second accommodating space and includes an inner wall surface and an outer wall surface opposite to each other, and the outer wall surface of the liquid-cooled shield faces an inner wall of the furnace body; a movable device fixed on an outer wall of the furnace body and is connected to the connectors, where the movable device is configured to move the liquid-cooled shield by moving the connectors; a flange fixed on the movable device, where a liquid inlet and a gas inlet are defined on the flange; a liquid feeding pipeline communicated with the liquid inlet, where the liquid feeding pipeline extends into the second accommodating space and communicates with the liquid-cooled shield; and a gas intake pipeline communicated with the gas inlet, where the gas intake pipeline extends into the second accommodating space and is fixed on the inner wall surface of the liquid-cooled shield, and the gas intake pipeline includes first gas outlets facing the inner wall surface of the liquid-cooled shield.

In some embodiments, the movable device includes a mounting bracket, and the flange includes an upper flange ring fixed on a top surface of the mounting bracket and a lower flange ring fixed on a bottom surface of the mounting bracket. A first through hole is defined on the mounting bracket, a second through hole is defined on the upper flange ring, a third through hole is defined on the lower flange ring, and each of the first through hole, the second through hole, and the third through hole aligns with the liquid inlet.

In some embodiments, the gas inlet includes: a first gas intake channel arranged inside the upper flange ring, where the first gas intake channel has an extension direction different from an extension direction of the liquid feeding pipeline; and a second gas intake channel communicated with the first gas intake channel, where the second gas intake channel is arranged to pass through the lower flange ring, communicate with the gas intake pipeline, and space apart from the liquid feeding pipeline.

Some embodiments of the present disclosure provide a method for manufacturing single crystal silicon rods, including: providing the single crystal furnace according to as illustrated above; feeding raw materials into the single crystal furnace to form a silicon melt; and manufacturing a single crystal silicon rod from the silicon melt using a Czochralski process, and feeding doping gas to the single crystal silicon rod through the gas intake pipeline during a shouldering growth process of the single crystal silicon rod.

In some embodiments, feeding the doping gas to the single crystal silicon rod through the gas intake pipeline during the shouldering growth process of the single crystal silicon rod, includes: measuring a length of the single crystal silicon rod; during growth of the length of the single crystal silicon rod to a first preset value, feeding a first number of moles of the doping gas at a first flow rate; and in response to the length of the single crystal silicon rod being greater than a second preset value, feeding a second number of moles of the doping gas at a second flow rate. The first number is greater than the second number.

In some embodiments, the method further includes: during the growth of the length of the single crystal silicon rod from the first preset value to the second preset value, controlling a flow rate of the doping gas to transition from the first flow rate to the second flow rate.

In some embodiments, the method further includes: during manufacturing the single crystal silicon rod, feeding inert gas continuously to the second accommodating space through the gas intake pipeline.

In some embodiments, the inert gas is fed at a flow rate of 50LPM to 100LPM.

In some embodiments, the single crystal furnace includes a plurality of gas intake pipelines. During the shouldering growth process of the single crystal silicon rod, each gas intake pipeline of the plurality of gas intake pipelines is configured to alternately feed inert gas and the doping gas, and gases fed by every two adjacent gas intake pipelines of the plurality of gas intake pipelines are different from each other during a same time period.

In some embodiments, the doping gas includes one or more simple substance gases of elements of Group VA.

The technical solutions provided in the embodiments of the present disclosure have at least the following advantages: by providing additional gas intake pipeline(s) that passes through the furnace body to the interior of the furnace body, gas can be directly fed to the second accommodating space, thereby preventing contamination of the gas during it enters the second and the first accommodating spaces via the third accommodating space, and preventing the quality of manufactured single crystal silicon rods from being affected. Moreover, by arranging the first gas outlets to face the liquid-cooled shield, the gas output from the gas intake pipeline(s) can be prevented from directly blowing on the liquid surface of the silicon melt, thereby ensuring the flowing velocity and stability of states of the gas when flowing across the liquid surface of the silicon melt, in order to prevent the fracture of single crystal silicon rods due to shake of the liquid surface. In addition, by directly feeding the gas to the second accommodating space, undesired turbulent flow due to flow of the gas can be prevent from forming in the furnace body. In this way, the gas can flow in an ideal pattern, therefore the single crystal silicon rods can grow according to an ideal model.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. The drawings do not constitute a scale limitation unless otherwise specified. In order to illustrate the technical solutions in related technologies or in the embodiments of the present disclosure more clearly, the drawings to be used in the embodiments will be briefly described below. It is obvious that the drawings mentioned in the following illustration are only some embodiments of the present disclosure. For those of ordinary skill in the art, other drawings may also be obtained in accordance with these drawings without any inventive effort.
FIG. 1 is a cross-sectional view of a single crystal furnace provided in some embodiments of the present disclosure.
FIG. 2 is a structural schematic diagram showing cooperation of the liquid-cooled shield and the liquid feeding pipeline provided in some embodiments of the present disclosure.
FIG. 3 is a structural schematic diagram showing cooperation of the flange and the movable device provided in some embodiments of the present disclosure.
FIG. 4 is a local cross-sectional view of a single crystal furnace provided in some embodiments of the present disclosure.
FIG. 5 is a locally enlarged schematic diagram showing a position of a first shunt provided in some embodiments of the present disclosure.
FIG. 6 is a cross-sectional view of a structure of another gas intake pipeline provided in some embodiments of the present disclosure.
FIG. 7 is a locally enlarged schematic diagram showing a structure of a gas intake pipeline provided in some embodiments of the present disclosure.
FIG. 8 is a flowchart of a method for manufacturing single crystal silicon rods provided in some embodiments of the present disclosure.

### DETAILED DESCRIPTION OF THE EMBODIMENTS

The single crystal silicon industry is booming, and the scale of manufacturing single crystal silicon for solar cells is becoming larger and larger. At the same time, the quality requirements for single crystal silicon are also increasing. In such a fiercely competitive situation, the process requirements of each process in the production are strictly controlled. Therefore, how to manufacture single crystal silicon having higher quality has become an attractive point in the industry. The single crystal silicon having higher quality usually means longer lifetime of minority carriers, lower oxygen content, and better radial and axial uniformity of resistivity of single crystal silicon wafers. However, the optimization of these three indicators has also become a pain point and difficulty point in the industry. Currently, it is impossible to improve the lifetime of minority carriers of silicon wafers while achieving better axial and radial uniformity of resistivity in the industry. In related technologies, gas is fed into the furnace body through an opening defined at a top of the furnace body. However, this conventional flow manner of gas will form vortices and cause dispersion of gas flow when the gas passes through the furnace crown, resulting in a decrease in gas pressure and a decrease in the effect of feeding gas.

The embodiments of the present disclosure provide a single crystal furnace and a method for manufacturing single crystal silicon rods. In the single crystal furnace, by providing additional gas intake pipeline(s) that passes through the furnace body to the interior of the furnace body, gas can be directly fed to the second accommodating space, thereby preventing contamination of the gas during it enters the second and the first accommodating spaces via the third accommodating space, and preventing the quality of manufactured single crystal silicon rods from being affected. Moreover, by arranging the first gas outlets to face the liquid-cooled shield, the gas output from the gas intake pipeline(s) can be prevented from directly blowing on the liquid surface of the silicon melt, thereby ensuring the flowing velocity and stability of states of the gas when flowing across the liquid surface of the silicon melt, in order to prevent the fracture of single crystal silicon rods due to shake of the liquid surface. In addition, by directly feeding the gas to the second accommodating space, undesired turbulent flow due to flow of the gas can be prevent from forming in the furnace body. In this way, the gas can flow in an ideal pattern, therefore the single crystal silicon rods can grow according to an ideal model.

In the illustration of the embodiments of the present disclosure, technical terms such as "first" and "second" are only used to distinguish different objects and shall not be understood as indicating or implying relative importance or implying the quantity, specific order, or primary and secondary relationship of the indicated technical features. In the illustration of the embodiments of the present disclosure, "a plurality of" refers to two or more, unless otherwise specified.

Referring to "embodiments" in the present disclosure means that specific features, structures, or characteristics described in conjunction with the embodiments may be included in at least one embodiment of the present disclosure. Referring to this phrase at various portions in the description does not necessarily relates to the same embodiment, nor an independent or alternative embodiment that is mutually exclusive with other embodiments. Those skilled in the art shall explicitly and implicitly understand that the embodiments described in the present disclosure can be combined with other embodiments.

In the illustration of the embodiments of the present disclosure, the term "and/or" is only used for describing the association relationships between associated objects, indicating that there can be three types of relationships. For example, A and/or B represents: the existence of A, the concurrent existence of A and B, and the existence of B. In addition, the character "/" in the present disclosure generally indicates that the associated objects are in an "or" relationship.

In the illustration of the embodiments of the present disclosure, the term "a plurality of" refers to two or more (including two). Similarly, "a plurality of groups" refers to two or more groups (including two groups), and "a plurality of pieces" refers to two or more pieces (including two pieces).

In the illustration of the embodiments of the present disclosure, the technical terms "center", "longitudinal", "transverse", "length", "width", "thickness", "up", "down", "front", "back", "left", "right", "vertical", "horizontal", "top", "bottom", "inside", "outside", "clockwise", "counterclockwise", "axial", "radial", "circumferential" and other directional or positional relationships are based on the directional or positional relationships shown in the accompanying drawings, only for the convenience of illustrating the embodiments of the present disclosure and simplifying the illustration, and do not indicate or imply that the devices or components referred to must have specific orientations, or be constructed and operated in specific orientations, and therefore shall not be understood as limitations on the embodiments of the present disclosure.

In the illustration of the embodiments of the present disclosure, unless otherwise specified and limited, technical terms such as "installation", "engagement", "connection", or "fixation" should be broadly understood. For example, "connection" may refer to fixed connections, detachable connections, integrated as a whole, mechanical connections or electrical connections, direct connections or indirect connections through an intermediate medium, or internal connections between two components or an interaction relationship between two components. For those skilled in the art, the specific meanings of the above terms in the embodiments of the present disclosure can be understood according to the specific situations.

In the drawings corresponding to the embodiments of the present disclosure, for better understanding and ease of illustration, thicknesses and areas of layers are enlarged. When a component (such as a layer, film, region, or substrate) is illustrated to be on the other component or on the surface of the other component, the component may be "directly" located on the surface of the other component, or there can be a third component between the two components. On the contrary, when a component is illustrated to be on the surface of the other component or when the other component is formed or arranged on the surface of the component, it indicates that there is no a third component between these two components. Furthermore, when a component is illustrated to be "substantially" formed on the other component, it means that the component is not formed on the entire surface (or front surface) of the other component, nor formed at some edges of the entire surface.

In the illustration of the embodiments of the present disclosure, when a component "includes" another component, other components are not excluded unless otherwise stated, and other components may be further included. In addition, when components such as layers, films, regions, or plates are referred to as being "on" another component, they may be "directly on" another component (i.e. there is no other components between them) or there may be other components present therebetween. In addition, when a component such as a layer, a film, a region, or a plate is "directly on" another component, or the component such as a layer, a film, a region, or a plate is at a surface of another component, it means that there are no other components between them.

The terms used in the illustration of various embodiments in the present disclosure are only intended to illustrate specific embodiments and are not intended to be limiting. As used in the illustration of various embodiments and the accompanying claims, "the component" is also intended to include the plural form, unless the context otherwise specifies. The component includes a layer, a film, a region, a plate, or the like.

Embodiments of the present disclosure will be described in detail below with reference to the accompanying drawings. Those skilled in the art shall understand that, in the embodiments of the present disclosure, many technical details are provided for the reader to better understand the embodiments of the present disclosure. However, even without these technical details and various modifications and variants based on the following embodiments, the technical solutions claimed in the present disclosure can be implemented.

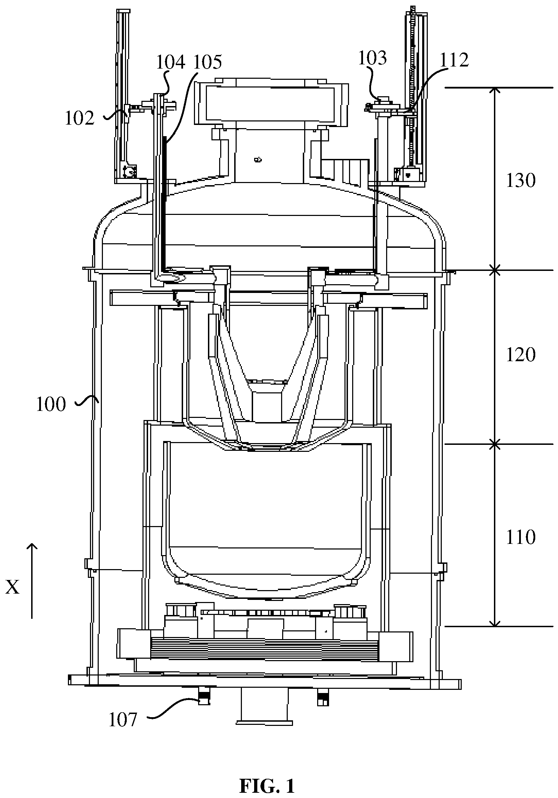

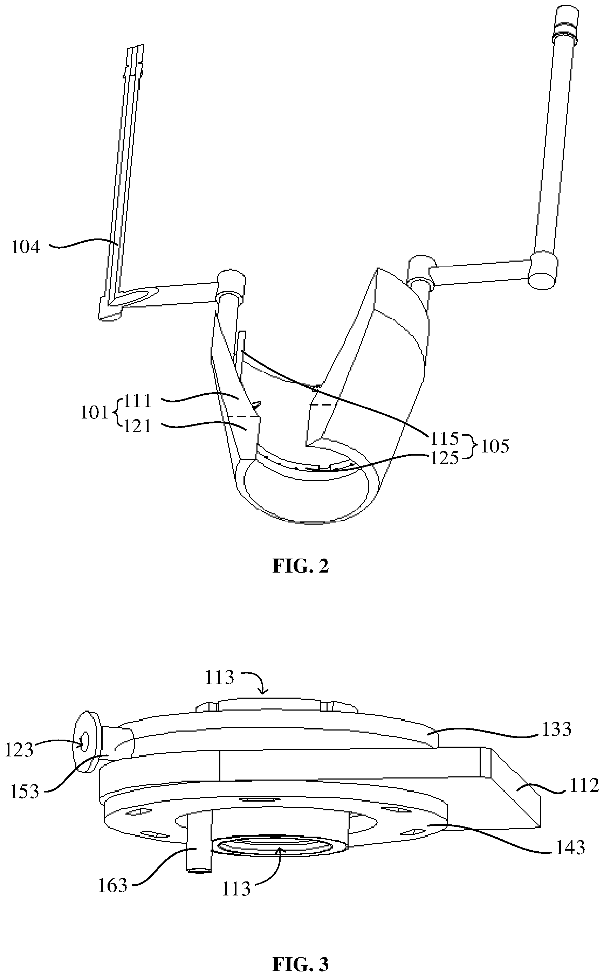

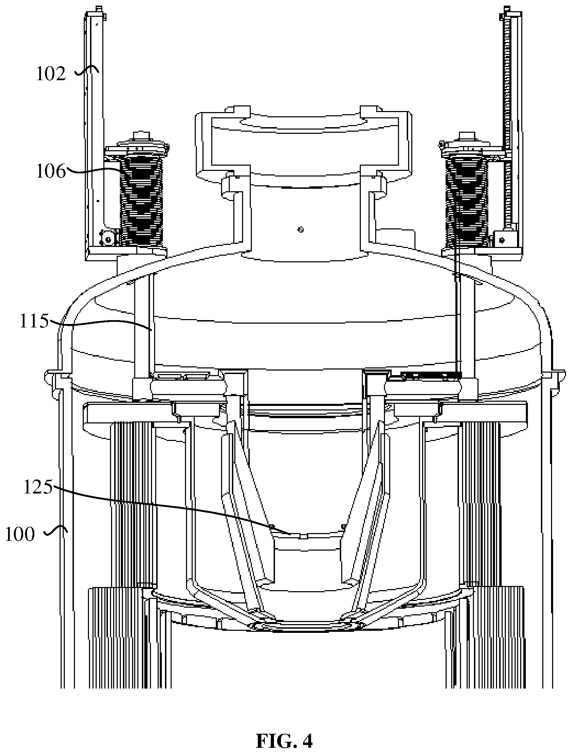

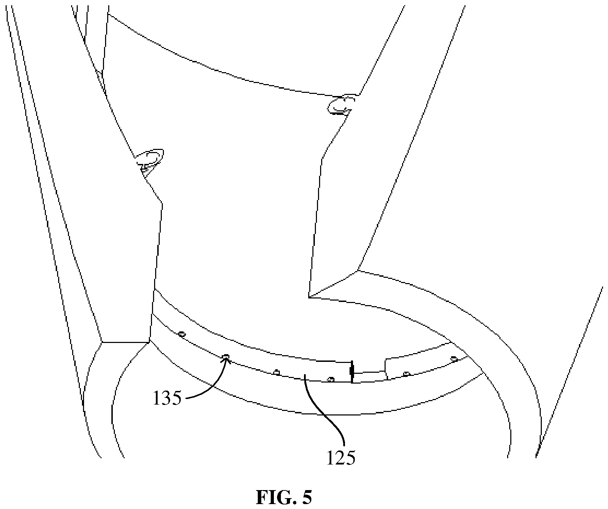

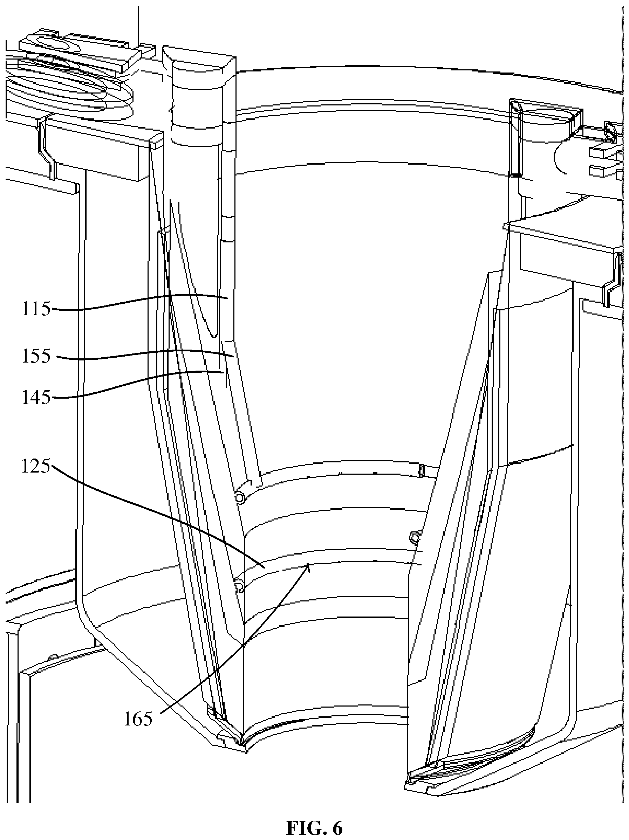

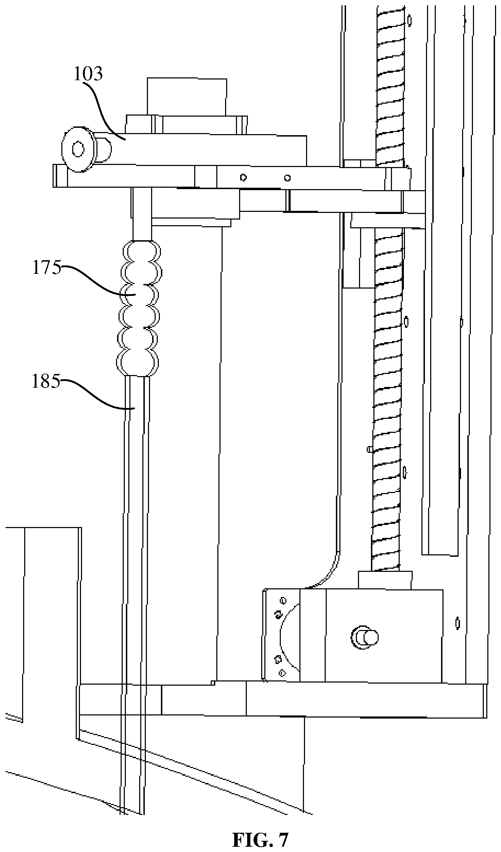

Referring to FIGS. 1 to 7, FIG. 1 is a cross-sectional view of a single crystal furnace provided in some embodiments of the present disclosure, FIG. 2 is a structural schematic diagram showing cooperation of the liquid-cooled shield and the liquid feeding pipeline provided in some embodiments of the present disclosure, FIG. 3 is a structural schematic diagram showing cooperation of the flange and the movable device provided in some embodiments of the present disclosure, FIG. 4 is a local cross-sectional view of a single crystal furnace provided in some embodiments of the present disclosure, FIG. 5 is a locally enlarged schematic diagram showing a position of a first shunt provided in some embodiments of the present disclosure, FIG. 6 is a cross-sectional view of a structure of another gas intake pipeline provided in some embodiments of the present disclosure, and FIG. 7 is a locally enlarged schematic diagram showing a structure of a gas intake pipeline provided in some embodiments of the present disclosure.

In some embodiments, the single crystal furnace includes a furnace body 100 including a first accommodating space 110, a second accommodating space 120, and a third accommodating space 130 arranged in sequence along a first direction X and communicated with each other. The first accommodating space 110 is configured to accommodate silicone fluids.

The single crystal furnace further includes a liquid-cooled shield 101 and connectors. The liquid-cooled shield 101 is arranged in the second accommodating space 120 and includes an inner wall surface and an outer wall surface opposite to each other. The outer wall surface of the liquid-cooled shield 101 faces an inner wall of the furnace body 100.

The single crystal furnace further includes a movable device 102 fixed on an outer wall of the furnace body 100 and is connected to the connectors. The movable device 102 is configured to move the liquid-cooled shield 101 by moving the connectors.

The single crystal furnace further includes a flange 103 fixed on the movable device 102. A liquid inlet 113 and a gas inlet 123 are defined on the flange 103.

The single crystal furnace further includes a liquid feeding pipeline 104 communicated with the liquid inlet 113. The liquid feeding pipeline 104 extends into the second accommodating space 120 and communicates with the liquid-cooled shield 101.

The single crystal furnace further includes a gas intake pipeline 105 communicated with the gas inlet 123. The gas intake pipeline 105 extends into the second accommodating space 120 and is fixed on the inner wall surface of the liquid-cooled shield 101. The gas intake pipeline 105 includes first gas outlets 135 facing the inner wall surface of the liquid-cooled shield 101.

By providing additional gas intake pipeline(s) 105 that passes through the furnace body 100 to the interior of the furnace body 100, gas can be directly fed to the second accommodating space 120, thereby preventing contamination of the gas during it enters the second accommodating space 120 and the first accommodating space 110 via the third accommodating space 130, and preventing the quality of manufactured single crystal silicon rods from being affected. Moreover, by arranging the first gas outlets 135 to face the liquid-cooled shield 101, the gas output from the gas intake pipeline(s) 105 can be prevented from directly blowing on the liquid surface of the silicon melt, thereby ensuring the flowing velocity and stability of states of the gas when flowing across the liquid surface of the silicon melt, in order to prevent the fracture of single crystal silicon rods due to shake of the liquid surface. In addition, by directly feeding the gas to the second accommodating space 120, undesired turbulent flow due to flow of the gas can be prevent from forming in the furnace body 100. In this way, the gas can flow in an ideal pattern, therefore the single crystal silicon rods can grow according to an ideal model.

The furnace body 100 is used to provide manufacturing space of the single crystal furnace. The furnace body 100 has characteristics such as high temperature resistance and good sealing. An opening is defined at the top of the furnace body 100. In related technologies, inert gas may be fed into the furnace through the opening, and impurities in the furnace can be brought out of the furnace by the inert gas. In the present disclosure, the opening is configured for feeding single crystal silicon materials into the furnace body 100 through the opening for manufacture. Inert gas may be fed into the furnace body 100 through the gas intake pipeline 105, and the outlet of the gas intake pipeline 105 is located in the second accommodating space 120. Therefore, the inert gas may be directly fed to the bottom of the furnace body 100 through the gas intake pipeline 105, thereby preventing metal impurities in the third accommodating space 130 from being brought into the silicon fluids, and improving the lifetime of the minority carriers in the formed single crystal silicon rods.

A crucible is provided in the furnace body 100 and is arranged in the first accommodating space 110. The crucible is configured to accommodate the silicon fluids.

The second accommodating space 120 and the third accommodating space 130 are configured to provide a crystal pulling space for formation of the single crystal silicon rods.

The liquid-cooled shield 101 and the liquid feeding pipeline 104 play a cooling role in the process of forming the single crystal silicon rods. The liquid-cooled shield 101 is hollow, and cooling liquid is continuously fed into the liquid-cooled shield 101 through the liquid feeding pipeline 104, thereby reducing the ambient temperature in the second accommodating space 120 and the first accommodating space 110, and providing a suitable manufacturing environment for the single crystal silicon rods.

A circular through hole for a single crystal silicon rod to pass through is defined at the bottom of the liquid-cooled shield 101, thereby providing space for the pulling of the single crystal silicon rod.

Referring to FIGS. 1 and 2, in some embodiments, the liquid-cooled shield 101 includes a first portion 111 and a second portion 121 communicated with each other. The second portion 121 is arranged between the first portion 111 and the first accommodating space 110, and the first gas outlets 135 face the inner wall surface of the first portion 111. In a direction directing from the second accommodating space 120 to the first accommodating space 110, the first portion 111 has a tapered shape, and a diameter of the second portion 121 remains unchanged.

In other words, the space enclosed by the first portion 111 has a shape of a conical frustum, and the space enclosed by the second portion 121 has a shape of a cylinder. For the liquid-cooled shield 101, the second portion 121 is the portion close to the first accommodating space 110. The closer it is to the accommodating space, the higher the temperature. Therefore, it is necessary to further get close to the single crystal silicon rod to achieve cooling. By arranging the first gas outlets 135 to face the inner wall of the first portion 111, on the one hand, interference with the pulling process of the single crystal silicon rod caused by the first gas outlets 135 can be prevented; on the other hand, the flow direction of the gas from the first gas outlets 135 can be prevented from directly facing the surface of the single crystal silicon rod or the surface of silicon fluids, thereby preventing the formation of the single crystal silicon rod from being affected.

The movable device 102 is fixed on an outer wall of the furnace body corresponding to the third accommodating space 130 and can move the liquid-cooled shield 101 along a first direction X by moving supporting rods of the liquid-cooled shield 101. In this way, different parts of the single crystal silicon rod can be cooled, so as to improve the reliability of the manufactured single crystal silicon rods.

Referring to FIGS. 1 and 3, in some embodiments, the movable device 102 includes a mounting bracket 112, and the flange 103 includes an upper flange ring 133 fixed on a top surface of the mounting bracket 112 and a lower flange ring 143 fixed on a bottom surface of the mounting bracket 112. A first through hole is defined on the mounting bracket 112, a second through hole is defined on the upper flange ring 133, a third through hole is defined on the lower flange ring 143, and each of the first through hole, the second through hole, and the third through hole aligns with the liquid inlet 113.

The mounting bracket 112 and the upper flange ring 133 may be fixedly connected to each other by screws, so as to fix the upper flange ring 133 to the mounting bracket 112, and the lower flange ring 143 may also be fixed to the mounting bracket 112 by screws, thereby achieving the fixation of the flange 103. Moreover, the first through hole, second through hole, and third through hole can facilitate input of cooling liquid into the liquid feeding pipeline 104. On the one hand, the fixing of the liquid feeding pipeline 104 can be achieved using the flange 103, and on the other hand, a specific liquid feeding structure can be provided by using the flange 103.

In some embodiments, a diameter of the second through hole may be larger than that of the liquid feeding pipeline 104, a diameter of the third through hole may be larger than that of the second through hole, and a diameter of the first through hole may be larger than that of the second through hole. In this way, the fixation of the liquid feeding pipeline 104 to the upper flange ring 133, the assembly of the lower flange ring 143 with the upper flange ring 133, and the assembly of the flange 103 with the mounting bracket 112 can be facilitated.

In some embodiments, a plurality of sealing gaskets may be arranged between the lower flange ring 143 and the liquid feeding pipeline 104 to improve the sealing degree of the single crystal furnace during manufacturing single crystal silicon rods using the liquid-cooled shield 101.

In some embodiments, the liquid feeding pipeline 104 may be made of 316L stainless steel material to meet the requirements of high temperature resistance.

In some embodiments, the gas inlet 123 includes: a first gas intake channel 153 arranged inside the upper flange ring 133, where the first gas intake channel 153 has an extension direction different from an extension direction of the liquid feeding pipeline 104; and a second gas intake channel 163 communicated with the first gas intake channel 153, where the second gas intake channel 163 is arranged to pass through the lower flange ring 143, communicate with the gas intake pipeline 105, and space apart from the liquid feeding pipeline 104. In other words, the first gas intake channel 153 and the second gas intake channel 163 are opened on the flange 103, so as to fix the liquid feeding pipeline 104 and the gas intake pipeline 105 using the flange 103. The first gas intake channel 153 is arranged to extend along a direction intersecting with the first direction X, so as to avoid the liquid feeding pipeline 104 and prevent mutual interference between the gas inlet 123 and the liquid inlet 113, thereby improving the reliability of the single crystal furnace. Moreover, by changing the extension direction of the first gas intake channel 153, the possibility of feeding wrong materials into the gas inlet 123 and the liquid inlet 113 can be reduced, thereby preventing problems such as feeding cooling liquid into the gas inlet 123.

In some embodiments, the diameter of the third through hole is larger than that of the second through hole, and the second gas intake channel 163 may pass through the third through hole to communicate with the gas intake pipeline 105, thereby feeding the required gas into the gas intake pipeline 105.

A thickness of the upper flange ring 133 may be in a range of 18mm to 28mm, such as 21mm, 23mm, 25mm, or 27mm, or the like. By thickening the upper flange ring 133, the formation of the first gas intake channel 153 can be facilitated.

Referring to FIGS. 1, 2, 4, and 5, in some embodiments, the gas intake pipeline 105 may include: a gas intake branch 115 communicated with the gas inlet 123, where the gas intake branch 115 extends into the second accommodating space 120 and is fixed to the inner wall surface of the first portion 111; and a first shunt 125 communicated with the gas intake branch 115 and extending along the circumferential direction of the inner wall surface of the first portion 111, where a plurality of first gas outlets 135 are defined on a side of the first shunt 125 away from the gas intake branch 115. Gas may be fed into the furnace body 100 through the gas intake branch 115, and then be output into the second accommodating space 120 through the first shunt 125.

In some embodiments, an included angle between the orientation of a first gas outlet 135 and the normal direction of the inner wall of the first portion 111 is in a range of 15° to 75°, such as 30°, 45°, 53°, 64°, 70°, or the like. When the included angle between the orientation of a first gas outlet 135 and the normal direction of the inner wall of the first portion 111 is too small, the first gas outlets 135 face the single crystal silicon rod or the liquid surface of the silicon fluids, leading to direct blowing on the liquid surface by the gas and therefore fracture of single crystal silicon rods due to shake of the liquid surface. By arranging the included angle between the orientation of a first gas outlet 135 and the normal direction of the inner wall of the first portion 111 to be in the range of 15° to 75°, direct blowing on the liquid surface or on the surface of the single crystal silicon rod by the gas can be prevented. In this way, the kinetic energy of the gas blowing on the single crystal silicon rod and liquid surface can be reduced, thereby improving the reliability of the single crystal furnace.

In some embodiments, the first shunt 125 has a hollow and annular shape, and the first gas outlets 135 are evenly arranged at intervals on both sides of the connection between the gas intake branch 115 and the first shunt 125. It can be understood that the gas has the highest velocity at the connection between the gas intake branch 115 and the first shunt 125. When the first gas outlets 135 are arranged at the connection between the gas intake branch 115 and the first shunt 125, a large amount of gas will flow out from this connection, resulting in uneven amount of gas flowing out from the first gas outlets 135, thereby affecting the reliability of the manufactured single crystal silicon rods. Therefore, by arranging the first gas outlets 135 on both sides of the connection between the gas intake branch 115 and the first shunt 125, the uniformity of amount of gas flowing out from the first gas outlets 135 can be improved, thereby improving the reliability of the manufactured single crystal silicon rods.

In some embodiments, a respective distance between every two adjacent first gas outlets 135 may be in a range of 20mm to 30 mm, such as 22mm, 24mm, 25mm, 27mm, 29mm, or the like. When the respective distance is too small, the gas flows output from different first gas outlets 135 will interfere with each other, resulting in poor gas exhaust effect. When the respective distance is too large, uneven doping based on the doping gas may occur. Therefore, the respective distance is designed to be in the range of 20mm to 30 mm.

In some embodiments, a diameter of a first gas outlet 135 may be in a range of 3mm to 8mm, for example 4mm, 5mm, 6mm, 7mm, or the like. With the diameter of the first gas outlet 135, the flow rate of the gas flowing out via the first gas outlet 135 and the effective range of gas can be controlled.

It is noted that the above-mentioned effective range of gas refers to an area in which the gas has relatively good effect. Taking the sprayed doping gas as an example, the effective range of gas here refers to the area in which the doping effect of the gas flowing out through the first gas outlets 135 is within expectation.

Referring to FIG. 6, in some embodiments, the gas intake pipeline 105 may further include: a diversion branch 145 communicated with the gas intake branch 115, the diversion branch 145 extends across the first portion 111 and to the second portion 121; and a second shunt 155 fixed on the inner wall surface of the liquid-cooled shield 101 and communicated with the diversion branch 145, where second gas outlets 165 are defined on the second shunt 155.

That is to say, the gas intake pipeline 105 includes two segments, the gas outlets 135 defined on one segment are located in the first portion 111 of the liquid-cooled shield 101, and the gas outlets 165 defined on the other segment are located in the second portion 121 of the liquid-cooled shield 101. By arranging the gas outlets 135 in the first portion 111 and arranging the gas outlets 165 in the second portion 121 of the liquid-cooled shield 101, when inert gas is fed into the gas intake pipeline 105, the efficiency of the inert gas in removing volatile impurities can be improved. Moreover, by directly feeding the inert gas into the second accommodating space 120, the kinetic energy consumed in the process of feeding the inert gas can be reduced, which can decrease the consumption of the inert gas. When doping gas is fed into the gas intake pipeline 105, the uniformity and concentration of doping can be improved, thereby reducing the resistivity of the single crystal silicon rods.

In some embodiments, the second gas outlets 165 face the first accommodating space 110, and an included angle between the orientation of a second gas outlet 165 and the first direction X is in a range of 30° to 60°, such as 35°, 43°, 48°, 55°, 58°, or the like. Similarly, in this way, direct blowing on the liquid surface by the gas from the second gas outlets 165 and therefore shake of the liquid surface can be prevented, thereby improving the reliability of the single crystal furnace.

In some embodiments, a second gas outlet 165 has an area larger than that of a first gas outlet 135. It can be understood that the second gas outlets 165 are located below the first gas outlets 135, and the gas will first flow out via the first gas outlets 135 and then flow out via the second gas outlets 165. Therefore, in order to improve the uniformity of the gas flew out, the second gas outlets 165 have larger areas, thereby improving the uniformity of output from the first gas outlets 135 and the second gas outlets 165.

In some embodiments, the single crystal furnace includes a plurality of gas intake pipelines 105 that are not in communication with each other. It can be understood that when the plurality of gas intake pipelines 105 are in communication with each other, taking two gas intake pipelines 105 communicated with each other as an example, when gas is fed into the single crystal furnace through these two gas intake pipelines, it is inevitable that turbulence will occur in these two gas intake pipelines 105, and the gases flowing against lead to decrease in the kinetic energy of the gases. When inert gas is fed, the ability of the inert gas to carry away oxygen in the furnace body 100 will be degraded, resulting in a decrease in the performance of the formed single crystal silicon rods. When doping gas is fed, the doping effect will also be decreased. Therefore, the gas intake pipelines 105 that are not in communication with each other will improve the performance of the single crystal furnace in manufacturing single crystal silicon rods.

In some embodiments, the more gas intake pipelines 105 there are, the more uniform the gas fed into the single crystal furnace will be. However, the more gas intake pipelines 105 there are, the more difficult it is to mount them on the single crystal furnace, and the higher the cost. Therefore, the number of the gas intake pipelines 105 is usually selected from 2 to 4, in order to improve the uniformity of the gas fed into the single crystal furnace, and to reduce the cost of the single crystal furnace.

Referring to FIGS. 1 and 7, in some embodiments, the gas intake pipeline 105 includes: a first sub-pipeline 175 communicated with the second gas intake channel 163 and arranged on the outer side of the furnace body 100; and a second sub-pipeline 185 fixed on the outer surface of the liquid feeding pipeline 104. The second sub-pipeline 185 is communicated with the first sub-pipeline 175 and extends into the second accommodating space 120. The first sub-pipeline 175 is configured to communicate the second sub-pipeline 185 with the second gas intake channel 163, and the second sub-pipeline 185 is configured to fed gas into the single crystal furnace. The second sub-pipeline 185 may be directly fixed on the outer surface of the liquid feeding pipeline 104 to prevent displacement of the pipeline. The first sub-pipeline 175 is configured to eliminate the assembly errors in the assembly of the gas intake pipeline 105, thereby improving the adaptability of the pipeline.

The first sub-pipeline 175 may be implemented as a metal hose, which can meet the temperature requirements for manufacturing single crystal silicon and can improve the versatility of the first sub-pipeline 175. Moreover, during mounting, sometimes adjustment of the flange 103 may be needed. When the second sub-pipeline 185 is in direct communication with the second gas intake channel 163, it is not convenient to adjust the flange 103. In addition, in the manufacturing process, the movable device 102 will move the liquid-cooled shield 101 along the first direction X, and during movement, vibrations will occur in the gaps. When the second sub-pipeline 185 is in direct communication with the second gas intake channel 163, the reliability will decrease. In view of this, the reliability of the single crystal furnace can be improved by providing an additional metal hose.

Referring to FIG. 4, in some embodiments, the single crystal furnace further includes bellows 106. One end of each bellows 106 is fixed to the bottom of the flange 103, and the other end is fixed on the surface of the furnace body 100. The bellows 106 surround the liquid feeding pipeline 104 and the gas intake pipeline 105. On the one hand, the bellows 106 can improve the sealing between the liquid feeding pipeline 104 and the liquid inlet 113, and also can improve the sealing between the gas intake pipeline 105 and the gas inlet 123. On the other hand, since the movable device 102 moves the liquid-cooled shield 101 during the manufacturing process, the bellows 106 can also adapt to the movement of the movable device 102.

Referring to FIG. 1, in some embodiments, the single crystal furnace may further include an exhaust device 107 arranged at the bottom of the furnace body 100 and communicated with the first accommodating space 110. With the exhaust device 107, a negative pressure state can be maintained inside the furnace body 100, allowing the fed inert gas to carry away the volatile matters such as silicon oxide, thereby improving the reliability of the manufactured single crystal silicon.

The single crystal furnace provided in the embodiments of the present disclosure can increase the temperature gradient at the liquid surface for forming the single crystal silicon rod, which is beneficial for increasing the pulling speed. The increase in the longitudinal temperature gradient at the liquid surface for forming the single crystal silicon rod implies that the flow velocity of the gas over the liquid surface for forming the single crystal silicon rod is increased, making it easier to carry away the volatile matters and lower the oxygen content.

In the single crystal furnace provided in the embodiments of the present disclosure, by providing additional gas intake pipeline(s) 105 that passes through the furnace body 100 to the interior of the furnace body 100, gas can be directly fed to the second accommodating space 120, thereby preventing contamination of the gas during it enters the second accommodating space 120 and the first accommodating space 110 via the third accommodating space 130, and preventing the quality of manufactured single crystal silicon rods from being affected. Moreover, by arranging the first gas outlets 135 to face the liquid-cooled shield 101, the gas output from the gas intake pipeline(s) 105 can be prevented from directly blowing on the liquid surface of the silicon melt, thereby ensuring the flowing velocity and stability of states of the gas when flowing across the liquid surface of the silicon melt, in order to prevent the fracture of single crystal silicon rods due to shake of the liquid surface. In addition, by directly feeding the gas to the second accommodating space 120, undesired turbulent flow due to flow of the gas can be prevent from forming in the furnace body 100. In this way, the gas can flow in an ideal pattern, therefore the single crystal silicon rods can grow according to an ideal model.

Some embodiments of the present disclosure provide a method for manufacturing single crystal silicon rods, in which the single crystal furnace as illustrated in some of or all the embodiments hereinbefore is adopted. In the following, the manufacturing method provided in some embodiment of the present disclosure will be illustrated in conjunction with the accompanying drawings. It is noted that the parts that are the same as or in correspondence to those in the aforementioned embodiments may be referred to in the corresponding descriptions of the aforementioned embodiments, and will not be repeated below.

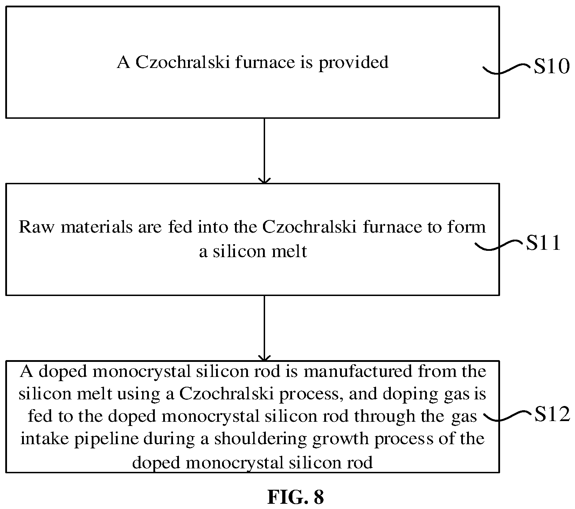

Referring to FIG. 8, FIG. 8 is a flowchart of a method for manufacturing single crystal silicon rods provided in some embodiments of the present disclosure.

In some embodiments, the method for manufacturing single crystal silicon rods may include: at S10, the single crystal furnace according to some of or all the embodiments hereinbefore is provided;
At S11, raw materials are fed into the single crystal furnace to form a silicon melt; and
At S12, a single crystal silicon rod is manufactured from the silicon melt using a Czochralski process, and doping gas is fed to the single crystal silicon rod through the gas intake pipeline during a shouldering growth process of the single crystal silicon rod.

In the embodiments of the present disclosure, during forming the single crystal silicon rod, pulling and gas doping can be performed concurrently by changing the doping method. In this way, the doping concentration inside the single crystal silicon rod can be further controlled, thereby controlling the axial resistivity and radial resistivity of the single crystal silicon rod within expectation. Moreover, during doping, the doping concentration can be controlled according to the resistivity requirements of the single crystal silicon rod, thereby controlling the resistivity of the single crystal silicon rod in real time.

In some embodiments, after the single crystal furnace is powered on, the raw materials are fed into the furnace body and the melting process begins. In this process, no gas is fed into the furnace body.

After the raw materials become silicon melt, inert gas may be fed into the single crystal furnace by connecting the flange to a gas feeding device, so as to reduce the oxygen content in the single crystal furnace.

In some embodiments, the operation of feeding the doping gas to the single crystal silicon rod includes: measuring a length of the single crystal silicon rod; during growth of the length of the single crystal silicon rod to a first preset value, feeding a first number of moles of the doping gas at a first flow rate; and in response to the length of the single crystal silicon rod being greater than a second preset value, feeding a second number of moles of the doping gas at a second flow rate. The first number is greater than the second number. In other words, the number of moles of doping gas fed to the head of the single crystal silicon rod is different from the number of moles of doping gas fed to the tail of the single crystal silicon rod. In this way, the difference between the resistivity of the head and the resistivity of the tail of the single crystal silicon rod can be controlled to be less than 15%, thereby improving the performance of the formed single crystal silicon rod. The values of the first flow rate and the second flow rate may be set according to actual situations, as long as the first number of moles of the doping gas is greater than the second number of moles of the doping gas.

In some embodiments, during the growth of the length of the single crystal silicon rod from the first preset value to the second preset value, a flow rate of the doping gas is controlled to transition from the first flow rate to the second flow rate. That is to say, with the formation of the single crystal silicon rod, the number of moles of the fed doping gas will gradually decrease, thereby preventing the occurrence of sudden changes in doping concentration and improving the performance of the single crystal silicon rod.

In some embodiments, the doping gas includes one or more simple substance gases of elements of Group VA. By doping the single crystal silicon rod during its growth process, the resistance of the formed single crystal silicon rod can be reduced. In the process of doping metal ion, in particular antimony, the uniformity of doping can be further improved by using gas doping compared to solid doping.

In some embodiments, during manufacturing the single crystal silicon rod, inert gas is continuously fed to the second accommodating space through the gas intake pipeline. On the one hand, by feeding the inert gas, the oxide in the furnace body can be brought out of the furnace body, so as to improve the performance of the manufactured single crystal silicon rod. On the other hand, by feeding the inert gas into the second accommodating space through the gas intake pipeline, the gas can be directly fed to the second accommodating space, thereby reducing the loss in kinetic energy of the inert gas in the third accommodating space, accelerating the rate of impurity removal, and achieving the effect of saving inert gas.

In some embodiments, the inert gas is fed at a flow rate of 50LPM to 100LPM. It can be understood that, compared to related technologies in which inert gas is directly fed through the opening at the top of the furnace body, in the embodiments of the present disclosure, the loss of inert gas can be reduced by directly feeding the gas to the second accommodating space through the gas intake pipeline. Therefore, the flow rate of the fed inert gas can also be accordingly set to save the inert gas.

In some embodiments, the single crystal furnace includes a plurality of gas intake pipelines. During the shouldering growth process of the single crystal silicon rod, each gas intake pipeline of the plurality of gas intake pipelines is configured to alternately feed inert gas and the doping gas, and gases fed by every two adjacent gas intake pipelines of the plurality of gas intake pipelines are different from each other during a same time period. For example, taking a single crystal furnace including two gas intake pipelines as an example, one gas intake pipeline is fed with inert gas, and the other gas intake pipeline is fed with doping gas. After a preset duration, the gases fed into the two gas intake pipelines exchange, thereby preventing the situation where one side of the single crystal silicon rod has relatively high doping concentration and the other side has relatively low doping concentration. Moreover, one gas intake pipeline is used to only feed the doping gas, the doping effect provided by this gas intake pipeline can be improved.

Similarly, the more gas intake pipelines there are, the smaller the difference in doping concentration at different portions of the single crystal silicon rod, and the number of gas intake pipelines may be adjusted according to demand.

The following will illustrate the method for manufacturing single crystal silicon rods provided in the embodiments of the present disclosure with a specific example. At the beginning of the shouldering growth process of the single crystal silicon rod, a controller for the doping gas may be turned on to control the amount of the doping gas fed into the gas intake pipelines according to the doping concentration corresponding to the required resistivity. In this process, a certain amount of doping gas is mixed with the inert gas and is together fed to the crystallization liquid surface, and at the crystallization liquid surface, the doping element in the inert gas will be absorbed and growth of the single crystal silicon rod will begin. Due to the fact that the doping gas is gaseous, it will be uniformly distributed in the silicon fluids. In related technologies, due to the existence of temperature gradient and convection during absorption of the doping element, in the radial direction, the resistance at center is relatively low and the resistance at edges is relatively high. In the doping method provided in the present disclosure, the doping gas is fed in such a way that most of the doping element is distributed at the periphery. In this way, the edge resistance can be reduced, and the uniformity of resistivity at the center and edges can be improved.

Those skilled in the art shall understand that the above-mentioned embodiments are specific examples for implementing the present disclosure. In practice, various changes may be made in form and details without departing from the scope of the present disclosure. Therefore, the patent scope of protection of the present disclosure shall be subject to the scope limited by the appended claims.

## Claims

1. A single crystal furnace, **characterized by** comprising:
a furnace body (100) including a first accommodating space (110), a second accommodating space (120), and a third accommodating space (130) arranged in sequence along a first direction (X) and communicated with each other, wherein the first accommodating space (110) is configured to accommodate silicone fluids;
a liquid-cooled shield (101) and connectors, wherein the liquid-cooled shield (101) is arranged in the second accommodating space (120) and includes an inner wall surface and an outer wall surface opposite to each other, and wherein the outer wall surface of the liquid-cooled shield (101) faces an inner wall of the furnace body (100);
a movable device (102) fixed on an outer wall of the furnace body (100) and is connected to the connectors, wherein the movable device (102) is configured to move the liquid-cooled shield (101) by moving the connectors;
a flange (103) fixed on the movable device (102), wherein a liquid inlet (113) and a gas inlet (123) are defined on the flange (103);
a liquid feeding pipeline (104) communicated with the liquid inlet (113), wherein the liquid feeding pipeline (104) extends into the second accommodating space (120) and communicates with the liquid-cooled shield (101); and
a gas intake pipeline (105) communicated with the gas inlet (123), wherein the gas intake pipeline (105) extends into the second accommodating space (120) and is fixed on the inner wall surface of the liquid-cooled shield (101), and wherein the gas intake pipeline (105) includes first gas outlets (135) facing the inner wall surface of the liquid-cooled shield (101).

2. The single crystal furnace according to claim 1, **characterized in that** the movable device (102) includes a mounting bracket (112); and
the flange (103) includes an upper flange ring (133) fixed on a top surface of the mounting bracket (112) and a lower flange ring (143) fixed on a bottom surface of the mounting bracket (112);
wherein a first through hole is defined on the mounting bracket (112), a second through hole is defined on the upper flange ring (133), a third through hole is defined on the lower flange ring (143), and each of the first through hole, the second through hole, and the third through hole aligns with the liquid inlet (113).

3. The single crystal furnace according to claim 2, **characterized in that** the gas inlet (123) includes:
a first gas intake channel (153) arranged inside the upper flange ring (133), wherein the first gas intake channel (153) has an extension direction different from an extension direction of the liquid feeding pipeline (104); and
a second gas intake channel (163) communicated with the first gas intake channel (153), wherein the second gas intake channel (163) is arranged to pass through the lower flange ring (143), communicate with the gas intake pipeline (105), and space apart from the liquid feeding pipeline (104).

4. The single crystal furnace according to any one of claims of 1 to 3, **characterized in that** the liquid-cooled shield (101) includes a first portion (111) and a second portion (121) communicated with each other;
wherein the second portion (121) is arranged between the first portion (111) and the first accommodating space (110), and the first gas outlets (135) face an inner wall surface of the first portion (111); and
wherein in a direction directing from the second accommodating space (120) to the first accommodating space (110), the first portion (111) has a tapered shape, and a diameter of the second portion (121) remains unchanged.

5. The single crystal furnace according to claim 4, **characterized in that** the gas intake pipeline (105) includes:
a gas intake branch (115) communicated with the gas inlet (123), wherein the gas intake branch (115) extends into the second accommodating space (120) and is fixed to the inner wall surface of the first portion (111); and
a first shunt (125) communicated with the gas intake branch (115) and extending along a circumferential direction of the inner wall surface of the first portion (111), wherein the first gas outlets (135) are defined on a side of the first shunt (125) away from the gas intake branch *(115);*
wherein the first shunt (125) has a hollow and annular shape, and the first gas outlets (135) are evenly arranged at intervals on both sides of a connection between the gas intake branch (115) and the first shunt (125).

6. The single crystal furnace according to claim 5, **characterized in that** the gas intake pipeline (105) further includes:
a diversion branch (145) communicated with the gas intake branch (115), wherein the diversion branch (145) extends across the first portion (111) and to the second portion (121); and
a second shunt (155) fixed on the inner wall surface of the liquid-cooled shield (101) and communicated with the diversion branch (145), wherein second gas outlets (165) are defined on the second shunt (155);
wherein each second gas outlet of the second gas outlets (165) has an opening area larger than an opening area of one respective first gas outlet of the first gas outlets (135).

7. The single crystal furnace according to any one of claims of 3 to 6, **characterized in that** the gas intake pipeline (105) includes:
a first sub-pipeline (175) communicated with the second gas intake channel (163) and arranged on an outer side of the furnace body (100); and
a second sub-pipeline (185) fixed on an outer surface of the liquid feeding pipeline (104), wherein the second sub-pipeline (185) is communicated with the first sub-pipeline (175) and extends into the second accommodating space (120).

8. The single crystal furnace according to any one of claims of 1 to 7, **characterized in that** every two adjacent gas intake pipelines of the plurality of gas intake pipelines (105) are not in communication with each other.

9. A method for manufacturing single crystal silicon rods, **characterized by** comprising:
providing (S10) the single crystal furnace according to any one of claims 1 to 8;
feeding (S11) raw materials into the single crystal furnace to form a silicon melt; and
manufacturing (S12) a single crystal silicon rod from the silicon melt using a Czochralski process, and feeding doping gas to the single crystal silicon rod through the gas intake pipeline (105) during a shouldering growth process of the single crystal silicon rod.

10. The method according to claim 9, **characterized in that** feeding the doping gas to the single crystal silicon rod through the gas intake pipeline (105) during the shouldering growth process of the single crystal silicon rod, includes:
measuring a length of the single crystal silicon rod;
during growth of the length of the single crystal silicon rod to a first preset value, feeding a first number of moles of the doping gas at a first flow rate; and
in response to the length of the single crystal silicon rod being greater than a second preset value, feeding a second number of moles of the doping gas at a second flow rate;
wherein the first number is greater than the second number.

11. The method according to claim 10, **characterized by** further including:
during the growth of the length of the single crystal silicon rod from the first preset value to the second preset value, controlling a flow rate of the doping gas to transition from the first flow rate to the second flow rate.

12. The method according to any one of claims 9 to 11, **characterized by** further including:
during manufacturing the single crystal silicon rod, feeding inert gas continuously to the second accommodating space (120) through the gas intake pipeline (105).

13. The method according to claim 12, **characterized in that** the inert gas is fed at a flow rate of 50LPM to 100LPM.

14. The method according to any one of claims 9 to 13, **characterized in that** the single crystal furnace includes a plurality of gas intake pipelines (105);
during the shouldering growth process of the single crystal silicon rod, each gas intake pipeline of the plurality of gas intake pipelines (105) is configured to alternately feed inert gas and the doping gas; and
gases fed by every two adjacent gas intake pipelines of the plurality of gas intake pipelines (105) are different from each other during a same time period.

15. The method according to any one of claims 9 to 14, **characterized in that** the doping gas includes one or more simple substance gases of elements of Group VA.
